# EUROPÄISCHE PATENTSCHRIFT

(11) **EP 4 215 935 B1**
(45) Veröffentlichungstag und Bekanntmachung des Hinweises auf die Patenterteilung: **21.05.2025**
(21) Anmeldenummer: 22152806.0
(22) Anmeldetag: 21.01.2022
(51) Int. Cl.: G01S 7/481, G01V 8/20

(54) **OPTISCHER SENSOR**
OPTICAL SENSOR
CAPTEUR OPTIQUE

(43) Veröffentlichungstag der Anmeldung: 26.07.2023
(73) Patentinhaber: Leuze electronic GmbH + Co. KG, 73277 Owen/Teck (DE)
(72) Erfinder: Feller, Bernhard, 86316 Friedberg (DE); Bortz, Jörg, 72805 Lichtenstein (DE); Gläser, Armin, 72639 Neuffen (DE); Nützel, Florian, 93128 Regenstauf (DE); Haberl, Paul, 80999 München (DE)
(74) Vertreter: Ruckh, Rainer Gerhard

(56) Entgegenhaltungen:
- EP-A1- 2 660 629
- EP-B1- 2 869 095
- CN-U- 209 196 521
- DE-A1- 10 215 536
- DE-A1- 102016 121 913
- DE-U1- 202012 102 874
- DE-U1- 8 512 541
- US-A1- 2010 328 947

## Beschreibung

Die Erfindung betrifft einen optischen Sensor.

Derartige optische Sensoren werden generell zur Erfassung von Objekten in einem Überwachungsbereich eingesetzt.

In der einfachsten Ausführungsform weist der optische Sensor als Sensorkomponente nur einen Lichtstrahlen emittierenden Sender und einen Lichtstrahlen empfangenden Empfänger auf. Der optische Sensor kann dabei als Lichttaster, Distanzsensor, Reflexionslichtschranke und dergleichen ausgebildet sein, wobei bei diesen Ausführungsformen der Sender und der Empfänger in einem gemeinsamen Gehäuse integriert sind. Weiterhin kann der optische Sensor auch als Lichtschranke ausgebildet sein. In diesem Fall sind der Sender und Empfänger in separaten Gehäusen untergebracht.

Generell kann der optische Sensor auch mehrere Sender und/oder Empfänger aufweisen. Ein Beispiel für einen derartigen optischen Sensor ist ein Lichtvorhang.

Der Lichtvorhang umfasst typischerweise in einem ersten Gehäuse an einem Rand des Überwachungsbereichs eine Reihenanordnung von Lichtstrahlen emittierenden Sendern und in einem zweiten Gehäuse an dem gegenüberliegenden Rand des Überwachungsbereichs eine Reihenanordnung von Lichtstrahlen empfangenden Empfängern.

Der optische Sensor weist als Elektronikkomponente eine Auswerteeinheit auf, in welcher in Abhängigkeit von Empfangssignalen des oder der Empfänger ein Objektfeststellungssignal generiert wird. Dieses Objektfeststellungssignal kann insbesondere als binäres Schaltsignal ausgebildet sein, dessen Schaltzustände angeben, ob sich ein Objekt im Überwachungsbereich befindet oder nicht. Das Objektfeststellungssignal kann alternativ ein analoges Signal, beispielsweise ein Distanzwert sein.

Die Sensorkomponenten und die Elektronikkomponenten des optischen Sensors sind auf wenigstens einer Leiterplatte angeordnet. Die oder jede Leiterplatte ist in dem oder in einem Gehäuse des optischen Sensors untergebracht.

Die jeweilige Leiterplatte muss exakt in einer bestimmten Sollposition gelagert werden. Dabei muss diese Sollposition auch bei äußeren Umgebungseinflüssen wie Schwingungs- oder Schwenkbelastungen erhalten bleiben. Um dies zu erreichen, werden die Leiterplatten in den jeweiligen Gehäusen mit Befestigungsmitteln fixiert. Ein Beispiel hierfür sind Schraubverbindungen.

Diese Befestigungen erfordern den Einsatz von Werkzeugen und sind zudem zeitaufwändig.

Die DE 102 15 536 A1 betrifft ein Gehäuse, insbesondere Sensorgehäuse, mit zumindest einem zur Aufnahme von Leiterplatten geeigneten Wandungselement. Das Gehäuse umfasst zumindest einen am Wandungselement ausgebildeten Kopplungsbereich, in dem eine Leiterplatte unter ungefähr 90 ° zu der Ebene des Wandungselements mit demselben verbindbar ist, und an dem Wandungselement fixierte elektrische Leitungselemente, die Abschnitte von Kopplungsbereichen untereinander und/oder mit anderen Bauelementen elektrisch leitend verbinden. Dabei sind die Kopplungsbereiche so ausgebildet, dass die Leiterplatte beim Verbinden mit dem Wandungselement sowohl an dem Wandungselement fixiert als auch mit den Leitungselementen in elektrisch leitenden Kontakt bringbar ist.

Die EP 2 660 629 A1 betrifft ein optisches Modul für einen Lichtvorhang. Das optische Modul weist eine Leiterplatte auf. Die Leiterplatte wird mittels Federelementen in Gehäuseaufnahmen gehalten.

Die DE 85 12 541 U1 betrifft eine Vorrichtung zum Halten von elektrischen oder elektronischen Bauelementen, wie z.B. Leuchtdioden an einer Platine eines Gerätes. Eine oder mehrere Leuchtdioden sind in eine mit einem Kabel verbundene Steckvorrichtung einsteckbar, wobei die Steckvorrichtung mittels Federhaken in einem Gehäuse festlegbar und das Gehäuse mittels weiterer Federhaken an eine Platine anklemmbar ist.

Die DE 10 2016 121 913 A1 betrifft eine Mehrstrahllichtschranke mit zwei Gehäusen, in welchen jeweils Sendermodule und Empfangsmodule vorhanden sind. Die Module weisen jeweils eine Leiterplatte auf, die mit Schnapphaken an einem Tubus befestigt ist.

Die US 2010/0328947 A1 betrifft eine Leuchtdiodenanordnung mit einer Anordnung von Leuchtdioden auf einer Leiterplatte. Die Leiterplatte ist flexibel, so dass diese durch Biegen an eine Aufnahmefläche einer Halterung angepasst und mit ihren Rändern in Ausnehmungen der Halterung eingesteckt werden kann.

Der Erfindung liegt die Aufgabe zugrunde einen optischen Sensor der eingangs genannten Art bereitzustellen, der rationell und kostengünstig gefestigt werden kann.

Zur Lösung dieser Aufgabe sind die Merkmale des Anspruchs 1 vorgesehen. Vorteilhafte Ausführungsformen und zweckmäßige Weiterbildungen der Erfindung sind in den abhängigen Ansprüchen beschrieben.

Die Erfindung betrifft einen optischen Sensor zur Erfassung von Objekten innerhalb eines Überwachungsbereichs mit Sensorkomponenten und Elektronickomponenten, welche in wenigstens einem Gehäuse angeordnet sind, in welchem wenigstens eine Sensorkomponenten und/oder Elektronikkomponente aufnehmende Leiterplatte gelagert ist. Die Leiterplatte ist in einer Aufnahme des Gehäuses dadurch spielfrei gelagert, dass bei in eine Sollposition in der Aufnahme eingebrachten Leiterplatte Elemente an der Leiterplatte verformt sind. Die Elemente an der Leiterplatte sind in der Aufnahme so verformbar, dass diese spielfrei in der Aufnahme gelagert sind.

Der erfindungsgemäße optische Sensor kann generell als Sensorkomponenten nur einen Sender und nur einen Empfänger aufweisen, wobei dann der optische Sensor als Lichtschranke, Reflexionslichtschranke, Lichttaster, Distanzsensor oder dergleichen ausgebildet sein kann. Der optische Sensor kann auch eine Mehrfachanordnung von Sendern und/oder Empfängern aufweisen. Insbesondere kann der optische Sensor als Lichtvorhang ausgebildet sein.

Die Funktionsweise des optischen Sensors ist generell derart, dass der optische Sensor als Elektronikkomponente eine Auswerteeinheit aufweist, in der abhängig von Empfangssignalen des oder der Empfänger ein Objektfeststellungssignal generiert, welches angibt, ob ein Objekt im Überwachungsbereich vorhanden ist.

Der optische Sensor kann generell als Sicherheitssensor ausgebildet sein. Für den Einsatz im Bereich der Sicherheitstechnik weist dieser einen fehlersicheren Aufbau auf, was beispielsweise durch eine zweikanalige Auswerteeinheit realisiert wird.

Erfindungsgemäß ist die oder jede Leiterplatte in einer zugeordneten Aufnahme des Gehäuses dadurch spielfrei gelagert, dass entweder die Leiterplatte beziehungsweise darauf angeordnete Elemente zumindest abschnittsweise verformbar sind. Wird die Leiterplatte in eine Sollposition in der zugeordneten Aufnahme eingebracht, ist diese durch die verformbaren Abschnitte spielfrei in der Aufnahme gelagert.

Die Leiterplatte ist damit reproduzierbar und stabil in der Sollposition gelagert. Die verformbaren Abschnitte gewährleisten dabei einen sicheren Halt der Leiterplatte in der Aufnahme auch bei vorhandenen externen Einflüssen wie zum Beispiel Schwingungs-, Stoß-, oder Schockbelastungen.

Dies ist insbesondere bei als Sicherheitssensoren ausgebildeten optischen Sensoren von Bedeutung, da diese strenge Anforderungen an die Unempfindlichkeit gegen derartige Belastungen erfüllen müssen.

Ein weiterer wesentlicher Vorteil der Erfindung besteht darin, dass die Leiterplatte werkzeuglos in den jeweiligen Aufnahmen fixiert werden können. Dadurch wird eine einfache und schnelle Montage des optischen Sensors ermöglicht.

Gemäß einer ersten Variante der Erfindung bildet die Leiterplatte in einem Randbereich ein federndes Gelenk aus, welches durch Verformung auslenkbar ist und welches in Eingriff mit der Aufnahme bringbar ist.

Das federnde Gelenk ist Bestandteil der Leiterplatte und kann somit im Herstellungsprozess der Leiterplatte rationell hergestellt werden.

Die Funktionsweise ist derart, dass bei Einführen der Leiterplatte in die jeweilige Aufnahme das federnde Gelenk ausgelenkt wird, wodurch das federnde Gelenk mit der Aufnahme verklemmt, verrastet oder dergleichen ist, wodurch die Leiterplatte ohne weitere Arbeitsprozesse, Hilfsmittel oder Befestigungsmittel positionsgenau und spielfrei in der Aufnahme gelagert ist.

Gemäß einer ersten vorteilhaften Ausführungsform ist das federnde Gelenk ein einstückig mit einem ebenen Körperteil der Leiterplatte ausgebildet und durch eine Aussparung von diesem abgesetztes Filmgelenk.

Die Funktion ist derart, dass in einer Ruhestellung das Filmgelenk seitlich über den Rand des Körperteils hervorsteht. Bei in eine die Aufnahme bildende Nut eingeführter Leiterplatte ist das Filmgelenk zwischen dem Körperteil und der Nut verpresst, wodurch die Leiterplatte spielfrei in der Aufnahme gelagert ist.

Im einfachsten Fall verlaufen die Grenzflächen des Filmgelenks parallel zu den Randflächen des Körperteils. Dazu wird bei Einführen der Leiterplatten in die Aufnahme das Filmgelenk in der Ebene der Leiterplatte ausgelenkt, wobei ein Verpressen der Leiterplatte in der Aufnahme erfolgt.

Alternativ kann das Filmgelenk Anfasungen aufweisen, sodass die dem Körperteil der Leiterplatten und/oder die der Aufnahme zugewandte Seite des Filmgelenks angeschrägt ist. Dies bewirkt, dass das Filmgelenk bei Verpressen in der Aufnahme aus der Ebene des Körperteils herausgelenkt wird, wodurch eine besonders effektive Verpressung der Leiterplatte in der Aufnahme erhalten wird.

Zweckmäßig weist bei diesen Ausführungsformen die Aufnahme zwei parallel zueinander verlaufende, im Gehäuse angeordnete Nuten auf, in welchen gegenüberliegende Ränder der Leiterplatte gelagert sind.

Für ein sicheres Verpressen der Leiterplatte in den Nuten reicht es aus, wenn auf einer der Seiten der Leiterplatte ein Filmgelenk vorhanden ist.

Gemäß einer weiteren Variante der Erfindung weist das Gehäuse einen Gehäusegrundkörper und eine auf eine Öffnung des Gehäusegrundkörpers aufsetzbare Gehäusekappe auf. Gegenüberliegende Randbereiche der Leiterplatte können in Nuten des Gehäusegrundkörpers gelagert werden, welche Bestandteile der Aufnahme sind.

In diesem Fall ist das Gehäuse zweiteilig ausgebildet. Die Leiterplatte wird dann zunächst in die Nuten des Gehäusegrundkörpers eingeschoben, wobei die Leiterplatte mit Spiel in den Nuten als Elemente der Aufnahme gelagert sein kann, zumindest solange bis die Gehäusekappe auf der Öffnung des Gehäusegrundkörpers fixiert ist. Die Lagefixierung erfolgt dann mittels der Gehäusekappe, in welcher entweder eine Aufnahme integriert ist oder mittels derer eine Lagesicherung, insbesondere ein Verklemmen der Leiterplatten in den Nuten erfolgt.

Gemäß einer ersten Ausführungsform ist das federnde Gelenk der Leiterplatte spielfrei an einer Innenwand der Gehäusekappe gelagert.

Zweckmäßig ist das federnde Gelenk mittels eines Formschlusselements spielfrei an der Innenwand der Gehäusekappe gelagert.

Die Innenwand der Gehäusekappe und das Formschlusselement bilden somit eine Aufnahme zur spielfreien Lagerung der Leiterplatte.

Je nach Ausbildung des Formschlusselements ist durch das Formschlusselement das federnde Gelenk aus der Ebene der Leiterplatte heraus ausgelenkt.

Gemäß einer weiteren Ausführungsform ist ein stirnseitiger Abschnitt der Leiterplatte mittels des federnden Gelenks in der Gehäusekappe so gelagert, dass die Leiterplatte schräg zur Längsachse der Gehäusekappe angeordnet ist. Nach Einführen der Leiterplatte in die Nuten des Gehäusegrundkörpers wird das federnde Gelenk gebogen, wodurch die Randbereiche der Leiterplatte unter Spannung in den Nuten gelagert sind.

In diesem Fall wird die Leiterplatte zunächst in die Nuten des Gehäusegrundkörpers eingeschoben, wobei diese zunächst mit Spiel in den Nuten liegt. Da die Leiterplatte schräg in der Gehäusekappe gelagert ist, ist dann die Gehäusekappe entsprechend schräg zum Gehäusegrundkörper orientiert. Zum Befestigen der Gehäusekappe am Gehäusegrundkörper muss die Gehäusekappe auf den Gehäusegrundkörper ausgerichtet werden, wodurch das federnde Gelenk ausgelenkt wird, was zu einem Schrägstellen der Leiterplatte in den Nuten und damit zu einem Verklemmen der Leiterplatte in den Nuten führt, wodurch die Leiterplatte spielfrei in ihrer Sollposition gelagert ist. Die Leiterplatte ist dann in dieser Position mittels der Gehäusekappe lagegesichert.

Vorteilhaft ist das federnde Gelenk ein an den stirnseitigen Rand der Leiterplatte anschließendes separates Element.

Alternativ kann ausgenutzt werden, dass die Leiterplatte selbst biegbar ist. Somit kann die Leiterplatte selbst das federnde Gelenk ausbilden.

Gemäß einer weiteren Ausführungsform weist die Leiterplatte einen Bereich mit verbreiterten Randbereichen auf, wobei diese Randbereiche unterschiedliche Höhen aufweisen.

Zweckmäßig sind die Randbereiche gegenüberliegend an der Leiterplatte angeordnet.

Die Höhenprofile der vorbereiteten Randbereiche der Leiterplatte sind so dimensioniert, dass bei schrägem Einführen der Randbereiche der Leiterplatte in die Nuten die Randbereiche mit Spiel in den Nuten geführt sind. Durch Ausrichten der Leiterplatte in der Ebene der Nuten sind die Randbereiche der Leiterplatte in den Nuten festgeklemmt. Die Leiterplatte ist mittels der Gehäusekappe in dieser Position lagefixiert.

Gemäß einer ersten Ausgestaltung sind lokale Erhöhungen in den Randbereichen der Leiterplatte Bestandteile der Leiterplatte.

Alternativ können auch lokale Erhöhungen in den Randbereichen der Leiterplatte von zusätzlichen Elementen gebildet sein.

Dabei können die zusätzlichen Elemente Lötpads, metallische Elemente oder Lötstopplack-Segmente sein.

Die metallischen Elemente können als Kupferpads ausgebildet sein.

Gemäß einer weiteren Ausführungsform ist die Leiterplatte durch eine Klemmverbindung mit der Gehäusekappe verbunden.

Der Gehäusekappe kann dabei einen von einem Bodenteil hervorstehenden Sockel aufweisen, der beispielsweise kreisscheibenförmig ausgebildet ist. Die Leiterplatte weist hierzu korrespondierende Bohrungen auf, die auf den Sockel geführt und dort eingerastet sind. Die Ränder, die die Bohrung der Leiterplatte begrenzen, verformen sich dabei etwas, so dass eine sichere Klemmverbindung erhalten wird. Dann wird die endseitig am Gehäusekappe befestigte Leiterplatte in die Nuten des Gehäusegrundkörpers eingeschoben. Dort kann die Leiterplatte mit Spiel gelagert sein, da bereits die Klemmverbindung für eine Lagesicherung der Leiterplatte sorgt.

Gemäß einer weiteren Variante der Erfindung sind Randbereiche der Leiterplatte angeschrägt, so dass bei in der Aufnahme eingeführter Leiterplatten ein spielfreier Formschluss entsteht.

Gemäß einer vorteilhaften Weiterbildung der Erfindung weist die Leiterplatte elektrisch leitfähige Kontaktelemente auf. Bei in der Aufnahme eingeführter Leiterplatte sind diese Kontaktelemente mit elektrisch leitfähigen Kontaktelementen der Aufnahme kontaktiert.

Mit dieser Kontaktierung können leitende Verbindungen zwischen Bauelementen auf der Leiterplatte und weiteren Bauelementen im Innenraum des Gehäuses hergestellt werden. Besonders vorteilhaft ist, dass die Kontaktierung völlig selbsttätig bei Einführen der Leiterplatte in die Sollposition in der Aufnahme erfolgt. Insbesondere ist vorteilhaft, dass zur Kontaktierung keine zusätzlichen Montageschritte erforderlich sind. Dadurch, dass die Leiterplatte in der Aufnahme durch Verklemmen sicher fixiert ist, ist auch ein sicherer Kontakt der Kontaktelemente der Leiterplatte und der Aufnahme gegeben.

Beispielsweise sind die Kontaktelemente der Leiterplatte Bauelemente oder Leiterbahnen.

Dabei können die Kontaktelemente der Leiterplatte aus Kupfer bestehen oder verzinnt oder vergoldet sein.

Weiterhin können die Kontaktelemente der Aufnahme aus leitfähigen Beschichtungen oder aus leitfähigen, oberflächenbehandelten Materialien bestehen.

Beispiele hierfür sind Aluminiumteile mit leitfähigen, zum Beispiel chromatierten Oberflächenbehandlungen oder Zinkdruckgussteile mit leifähigen, insbesondere vernickelten oder verchromten Oberflächenbeschichtungen.

Die Erfindung wird im Folgenden anhand der Zeichnungen erläutert. Es zeigen:
- Figur 1:: Ausführungsbeispiel des erfindungsgemäßen optischen Sensors in Form eines Lichtvorhangs.
- Figur 2:: Ausführungsbeispiel einer in Nuten eines Gehäuses einführbaren Leiterplatte mit einem Filmgelenk a) bei aus den Nuten teilweise ausgefahrenen Leiterplatten. b) bei in die Nuten eingefahrenen Leiterplatten. c) Schnittdarstellung der Anordnung gemäß Figur 2b.
- Figur 3a:: Variante der Leiterplatte gemäß Figur 2.
- Figuren 3b-e:: Unterschiedliche Ausbildungen der Filmgelenke der Leiterplatte gemäß Figur 3a sowie unterschiedliche Nuten.
- Figur 4a:: Anordnung mit einem Gehäusegrundkörper und einer Gehäusekappe zur spielfreien Lagerung einer Leiterplatte.
- Figur 4b:: Schnittdarstellung der Gehäusekappe der Anordnung gemäß Figur 4a.
- Figur 5:: Erste Variante der Anordnung gemäß Figur 4a.
- Figur 6:: Zweite Variante der Anordnung gemäß Figur 4a.
- Figur 7:: Dritte Variante der Anordnung gemäß Figur 4a.
- Figur 8a:: Darstellung einer schräg an einer Gehäusekappe gelagerten Leiterplatte.
- Figur 8b:: Einzeldarstellung eines der Gehäusekappe gemäß Figur 8a zugeordneten Gehäusegrundkörper.
- Figur 8c:: Darstellung der zusammenmontierten Einheiten der Figuren 8a, 8b.
- Figuren 9a-c:: Variante der Ausführungsform der Figuren 8a bis 8c.
- Figur 10:: Ausführungsbeispiel einer Gehäusekappe mit zugeordneten Leiterplatte a) zur Herstellung einer Klemmvorrichtung zwischen Gehäusekappe und Leiterplatte. b) nach Herstellung einer Klemmvorrichtung zwischen Gehäusekappe und Leiterplatte. c) Einzeldarstellung der Leiterplatte in einer Draufsicht.
- Figur 11:: a) Ausführungsbeispiel einer Leiterplatte mit verbreitetem Randbereich b) Leiterplatte gemäß Figur 11a bei Einführen in Nuten eines Gehäuses. c) Leiterplatte gemäß Figur 11a nach Einführen in Nuten eines Gehäuses.
- Figuren 12a-c:: Variante der Ausführungsform gemäß Figuren 11a bis c.

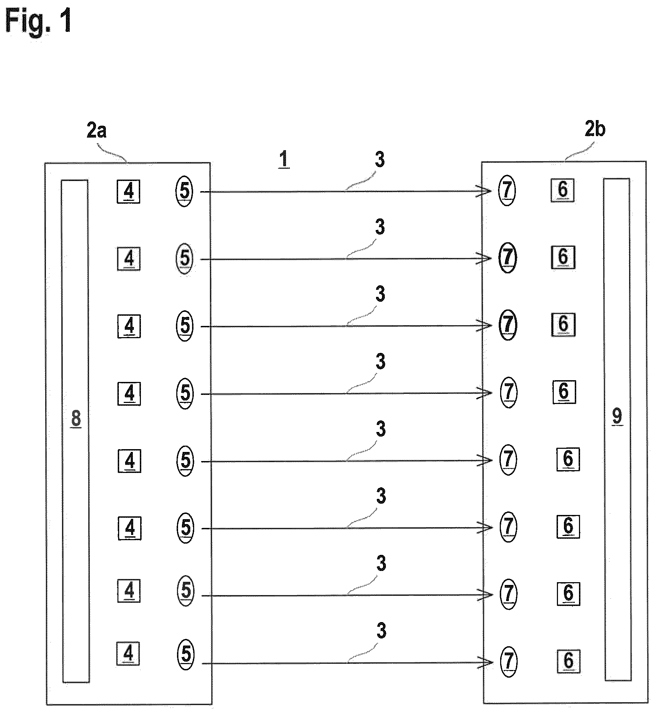

Figur 1 zeigt schematisch den Aufbau eines Ausführungsbeispiels des erfindungsgemäßen optischen Sensors in Form eines Lichtvorhangs 1 zur Erfassung von Objekten innerhalb eines Überwachungsbereichs.

Der Lichtvorhang 1 weist eine Sendereinheit mit einem Gehäuse 2a mit einer Reihenanordnung von Lichtstrahlen 3 emittierenden Sendern 4 und diesen zugeordneten Optikelementen bildenden Sendeoptiken 5 auf. Weiterhin weist der Lichtvorhang 1 eine Empfängereinheit mit einem zweiten Gehäuse 2b mit einer Reihenanordnung von Lichtstrahlen 3 empfangenden Empfängern 6 auf, welchen jeweils ein Optikelement in Form einer Empfangsoptik 7 vorgeordnet ist.

Die Gehäuse 2a, 2b sind an gegenüberliegenden Rändern des Überwachungsbereichs so angeordnet, dass jeweils ein Empfänger 6 einem Sender 4 gegenüberliegend angeordnet ist und mit diesem ein Sender-Empfänger-Paar bildet, wobei die Lichtstrahlen 3 des Senders 4 eine Strahlachse bilden. Im vorliegenden Fall sind acht Strahlachsen vorgesehen. Natürlich kann der Lichtvorhang 1 auch eine andere Zahl von Strahlachsen aufweisen.

Alternativ kann der Lichtvorhang 1 auch als Reflexions-Lichtvorhang ausgebildet sein. Dann sind alle Sender 4 und Empfänger 6 in einem Gehäuse 2a angeordnet, welche an einem Rand des Überwachungsbereichs angeordnet ist. Am anderen Ende befindet sich ein Reflektor. Bei freiem Überwachungsbereich werden die Lichtstrahlen 3 der Sender 4 über den Reflektor zurück zum jeweils zugeordneten Empfänger 6 geführt.

Die Sender 4 werden von einer Sendersteuerung 8 gesteuert. Den Empfängern 6 ist eine Auswerteeinheit 9 zugeordnet. Dabei werden die Strahlachsen zyklisch einzeln nacheinander aktiviert. Die Auswerteeinheit 9 steuert die Empfänger 6 an und wertet deren Empfangssignale zur Generierung eines Objektfeststellungssignals in Form eines binären Schaltsignals aus, dessen Schaltzustände angeben, ob sich ein Objekt im Überwachungsbereich befindet oder nicht. Bei freiem Überwachungsbereich gelangen die Lichtstrahlen 3 der Strahlachsen ungehindert zum Empfänger 6 der jeweiligen Strahlachse. Bei einem Objekteingriff wird wenigstens eine Strahlachse unterbrochen. Die Auswerteeinheit 9 kann einen mehrkanaligen Aufbau aufweisen, falls der Lichtvorhang 1 einen Sicherheitssensor bildet.

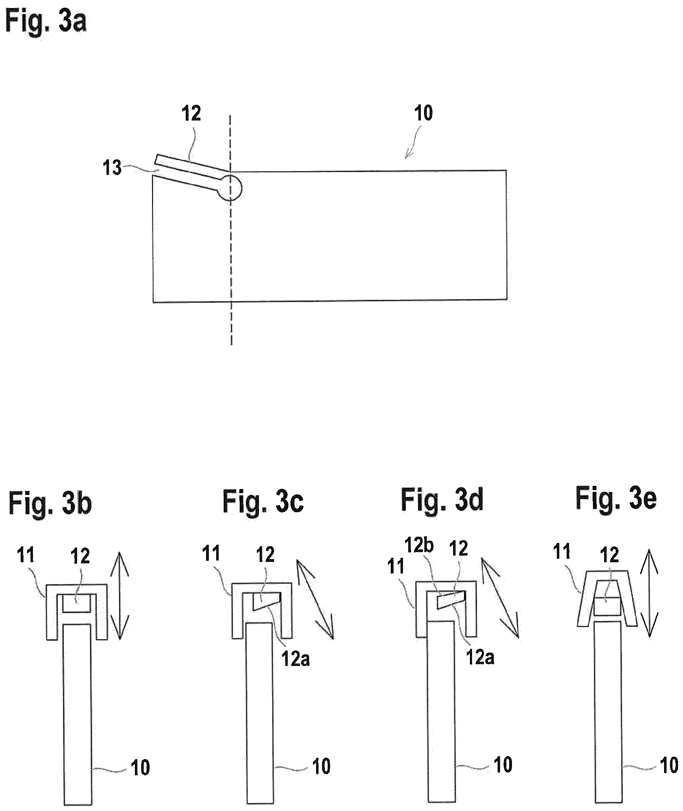

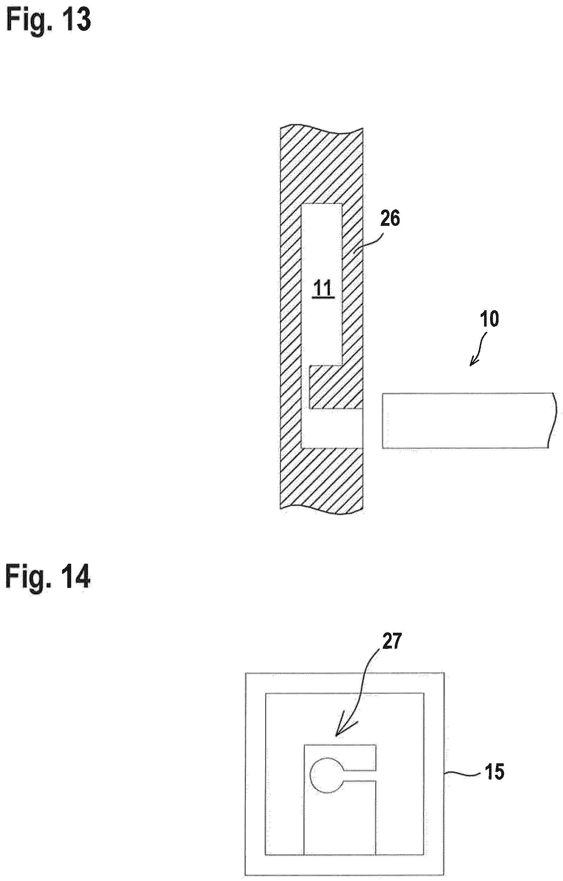

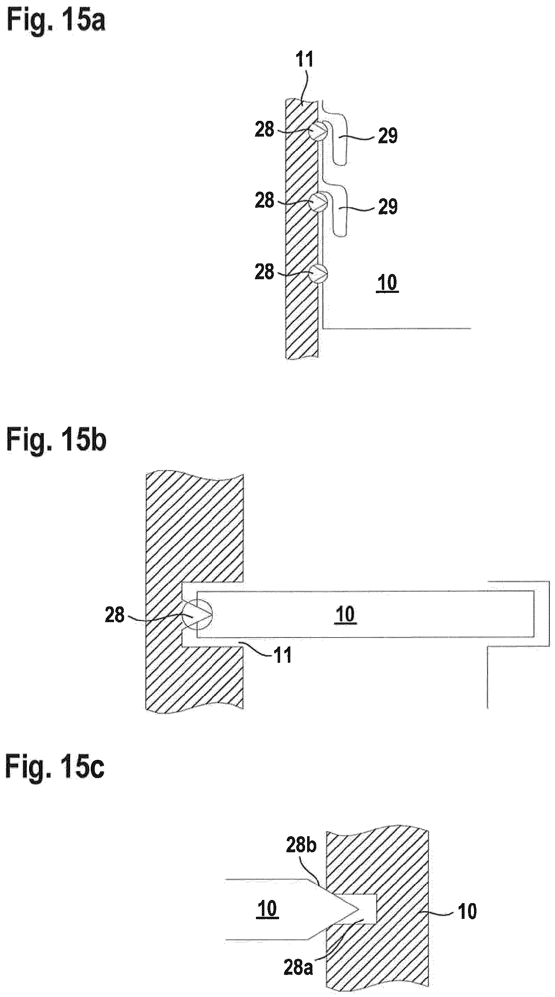

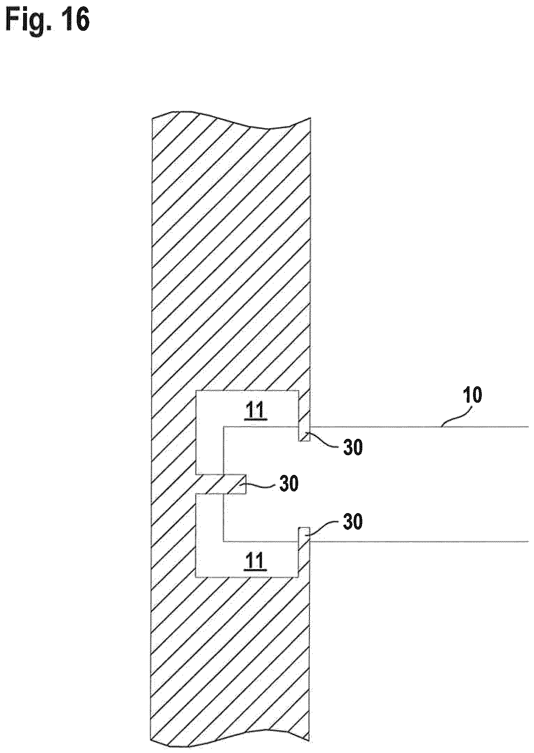

Die Sender 4 und Empfänger 6 bilden Sensorkomponenten des optischen Sensors. Die Sendersteuerung 8 und die Auswerteeinheit 9 bilden Elektronikkomponenten des optischen Sensors. Die Sensorkomponenten und Elektronikkomponenten sind auf Leiterplatten 10 angeordnet, die erfindungsgemäß in Aufnahmen der Gehäuse 2a, 2b dadurch spielfrei gelagert sind, dass bei Einbringen der Leiterplatte 10 in die jeweilige Aufnahme Elemente der Aufnahme oder Elemente der oder an der Leiterplatte 10 verformt sind. Ausführungsbeispiele hierfür zeigen die Figuren 3 - 16 für das Gehäuse 2b der Empfängereinheit, wobei dieselben Anforderungen auch für das Gehäuse 2a der Sendereinheit vorgesehen sind.

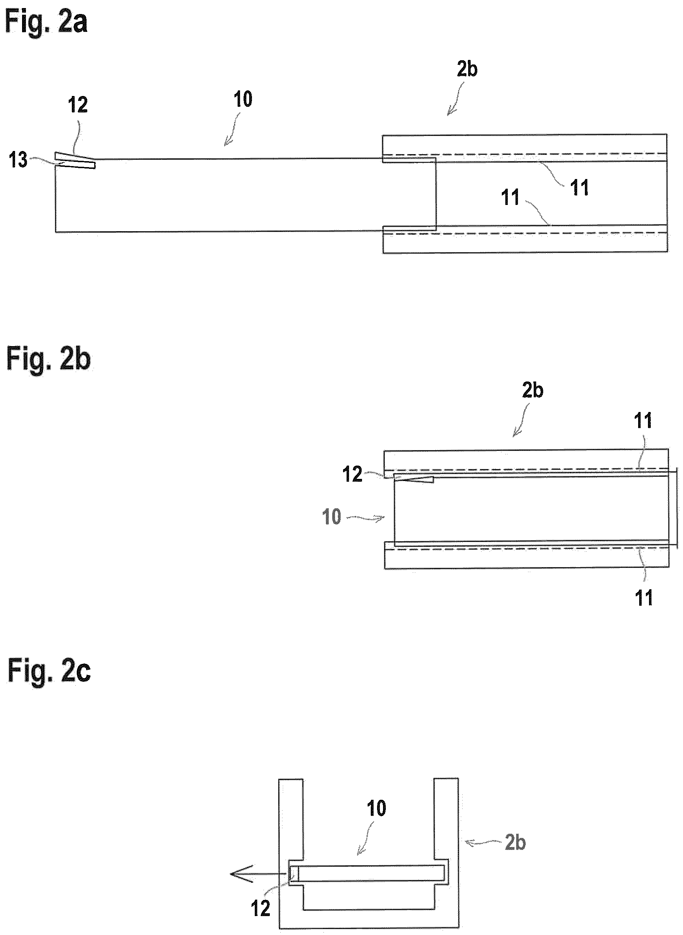

Figur 2a zeigt eine Aufnahme des Gehäuses 2b, in Form von Nuten 11, in welche eine Leiterplatte 10 eingeschoben werden kann. Die Nuten 11 verlaufen parallel in Abstand zueinander.

An einem Rand der Leiterplatte 10 ist ein Filmgelenk 12 vorgesehen, das einstückig mit der Leiterplatte 10 ausgebildet ist und durch eine Aussparung 13 vom Körperteil der Leiterplatte10 abgesetzt ist. Das Filmgelenk 12 steht seitlich über den Rand der Leiterplatte 10 hervor.

Wird die Leiterplatte 10 in die Nuten 11 eingeschoben, wird das Filmgelenk 12 zwischen dem Körperteil der Leiterplatte 10 und der Nut 11 festgeklemmt, wodurch die Leiterplatte 10 in einer Sollposition lagefixiert ist (Figuren 2b, 2c). Durch das Festklemmen wirkt eine mit einem Pfeil in Figur 2c gekennzeichnete Federkraft, die die Leiterplatte 10 in den Nuten 11 fixiert.

Figur 3a zeigt eine Variante der Leiterplatte 10 gemäß den Figuren 2a - 2c. In diesem Fall ist die Aussparung 13, die das Filmgelenk 12 vom Körperteil der Leiterplatte 10 absetzt, in ihrem hinteren Bereich kreisförmig verbreitert. Durch die Vorgabe der Breite des Filmgelenks 12 und die der Größe der Aussparung 13 können die elastischen Eigenschaften des Filmgelenks 12 vorgegeben werden.

Die Figuren 3b - 3e zeigen unterschiedliche Querschnitte des Filmgelenks 12 und der Nut 11. Die bei Verpressen des Filmgelenks 12 in der Nut 11 wirkenden Richtungen der Anpresskräfte sind mit Doppelpfeilen gekennzeichnet.

Bei den Ausführungen der Figuren 3b - 3d weist die Nut 11 einen rechteckigen Querschnitt auf. Bei der Ausführungsform der Figure 3e weist die Nut 11 einen konischen Querschnitt auf, wodurch zusätzlich eine Stabilisierungskraft der Leiterplatte 10 senkrecht zur Leiterplattenebene erhalten wird.

Bei den Ausführungsformen der Figuren der Figuren 3b, 3e sind die Grenzflächen des Filmgelenks 12 nicht angefast, das heißt sie verlaufen parallel zu den Grenzflächen des Körperteils der Leiterplatte 10 und zum Bodenteil 22 der Nut 11. Bei den Ausführungsformen der Figuren 3c, 3d sind diese Grenzflächen angefast, das heißt sie verlaufen schräg zu den Grenzflächen des Körperteils der Leiterplatte 10 und zum Bodenteil 22 der Nut 11. Dementsprechend verlaufen die Anpresskräfte bei den Ausführungsformen der Figuren 3b, 3e in der Leiterplattenebene, bei den Ausführungsformen der Figuren 3c, 3d schräg zu dieser.

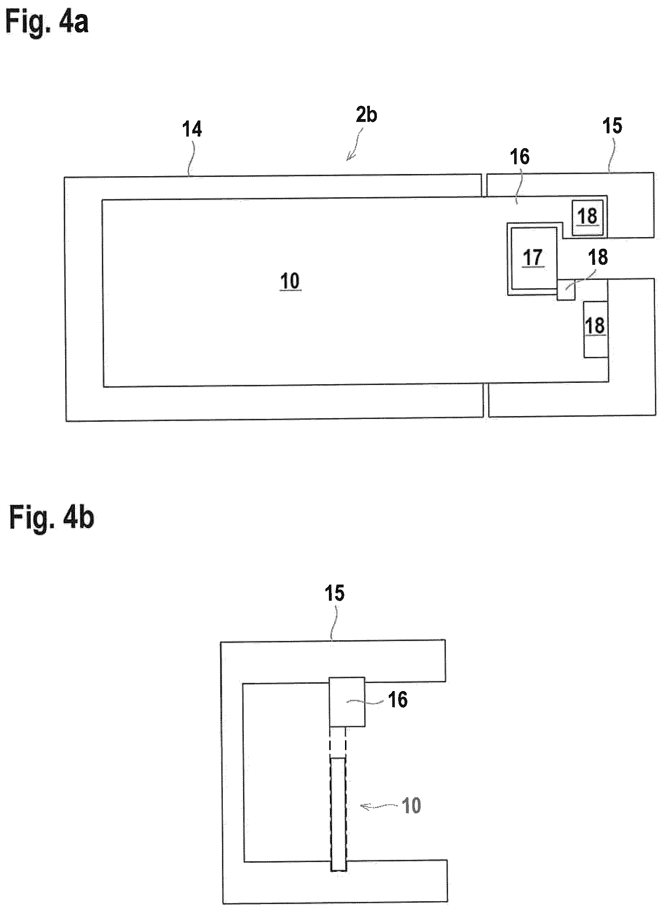

Die Figuren 4a, b zeigen ein Ausführungsbeispiel bei welchen das Gehäuse einen Gehäusegrundkörper 14 und eine Gehäusekappe 15, mit der eine Öffnung des Gehäusegrundkörpers 14 verschlossen werden kann, aufweist. Die Leiterplatte 10 kann in nicht gesondert dargestellten Nuten 11 des Gehäusegrundkörpers 14 eingeschoben werden, wobei die Leiterplatte 10 dort mit Spiel gelagert sein kann. Die Lagefixierung der Leiterplatte 10 erfolgt in der Gehäusekappe 15.

Wie die Figuren 4a, 4b zeigen, weist die Leiterplatte 10 einen federnden Leiterplattenabschnitt 16 der ein federndes Gelenk ausbildet, auf. Dieses wird durch ein klotzförmiges Formschlusselement 17 gegen eine Wand der Gehäusekappe 15 gedrückt, wodurch die Leiterplatte 10 spielfrei lagefixiert ist. Das Formschlusselement 17 ist in einer Ausnehmung zwischen dem federnden Gelenk und einem weiteren Segment der Leiterplatte 10 gelagert.

An der Leiterplatte 10 können elektrisch leitfähige Kontaktelemente 18 angeordnet sein, wobei in Figur 4a mehrere Konfigurationsmöglichkeiten dargestellt. Bei Fixieren der Leiterplatte 10 in der Sollposition durch Aufsetzen der Gehäusekappe 15 auf den Gehäusekappe 15 werden die Kontaktelemente 18 selbsttätig mit korrespondierenden, nicht dargestellten Kontaktelement 18 in der Gehäusekappe 15 elektrisch kontaktiert. Damit wird insbesondere eine elektrisch leitfähige Verbindung von Bauelementen auf der Leiterplatte 10 zu elektrischen Anschlussmitteln wie einem nicht dargestellten Kabelanschluss in der Gehäusekappe 15 hergestellt.

Entsprechende Kontaktelemente 18 können auch bei allen anderen Ausführungsbeispielen vorgesehen sein.

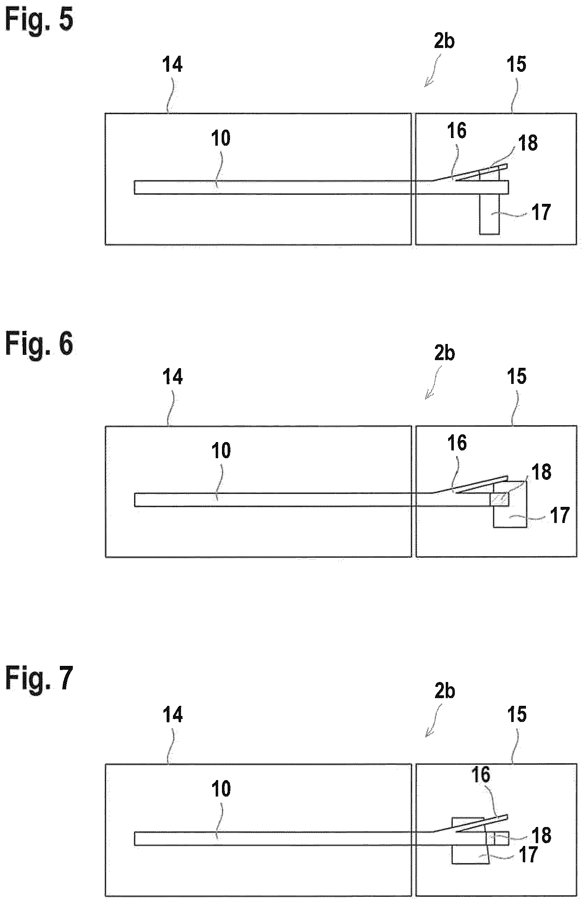

Die Figuren 5 - 7 zeigen Varianten der Anordnung gemäß den Figuren 4a, b die sich in der Ausbildung des Formschlusselements 17 und der Ankopplung der Leiterplatte 10 an dieses Formschlusselement 17 unterscheiden.

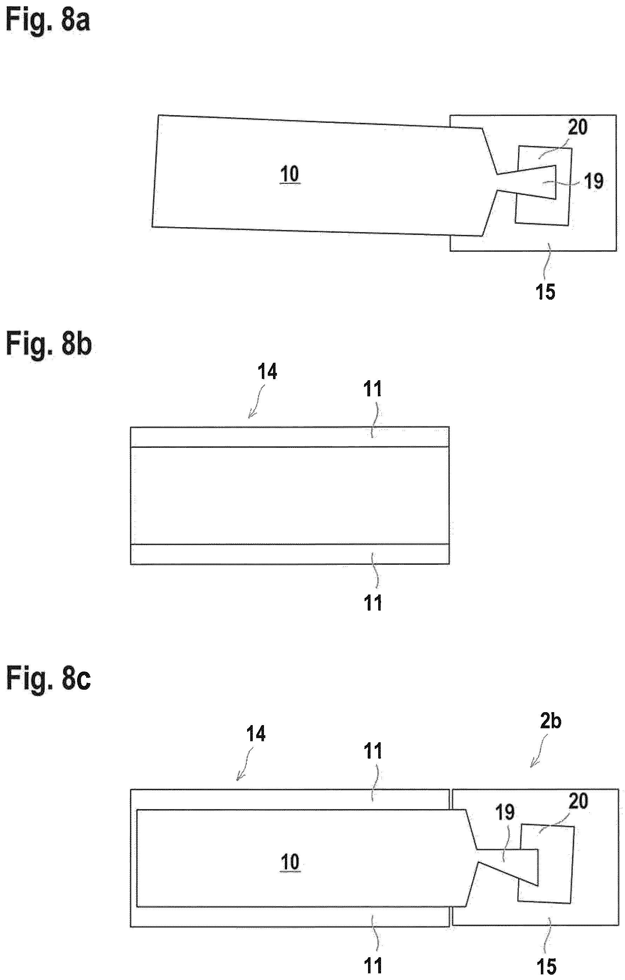

Die Figuren 8a - 8c zeigen ein weiteres Ausführungsbeispiel einer spielfreien Lagerung der Leiterplatte 10 in einer Aufnahme des Gehäuses 2b. Das Gehäuse umfasst wieder einen Gehäusegrundkörper 14 mit Nuten 11 zur Aufnahme der Leiterplatte 10 sowie eine Gehäusekappe 15. Die Leiterplatte 10 ist über elastisch verformbare Kopplungsmittel 19, die ein federndes Gelenk bilden, an die Gehäusekappe 15 angekoppelt, und zwar so, dass die Leiterplattenränder schräg zur Längsachse der Gehäusekappe 15 verlaufen. Die Kopplungsmittel 19 sind in einem Aufnahmeblock 20 der Gehäusekappe 15 gelagert.

Bei der Montage wird die Leiterplatte 10 in die Nuten 11 des Gehäusegrundkörper 14 eingeschoben, wobei die Leiterplattenebene in der Ebene der Nuten 11 liegen. Da die Leiterplatte 10 schräg in der Gehäusekappe 15 liegt, wird bei Aufsetzen der Gehäusekappe 15 auf den Gehäusegrundkörper 14 das federnde Gelenk ausgelenkt und die Leiterplatte 10 wird in den Nuten 11 verspannt und geklemmt und dadurch spielfrei gelagert.

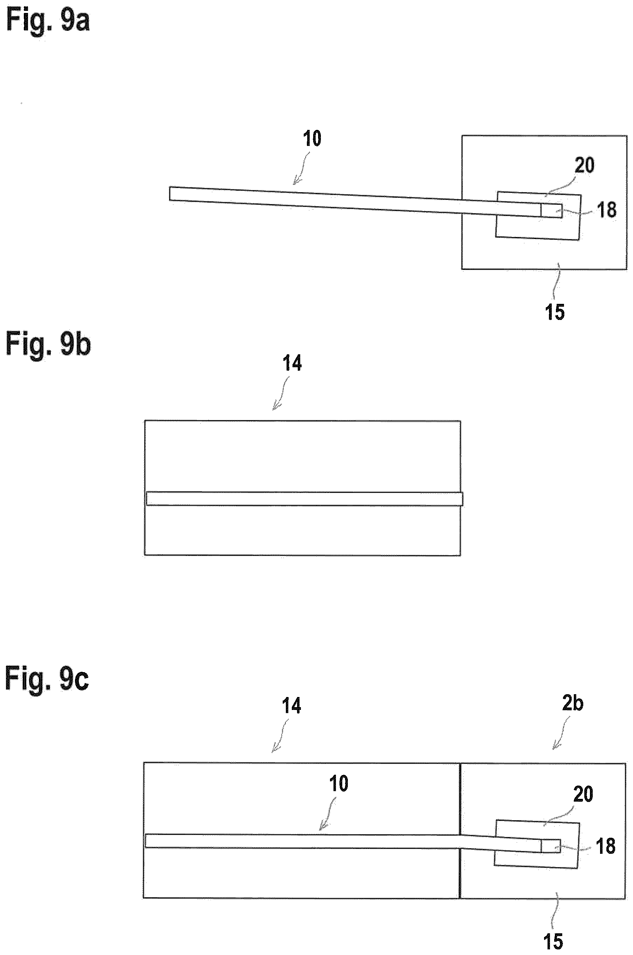

Die Figuren 9a - 9c zeigen eine Variante der Ausführungsform gemäß den Figuren 8a - c. Im vorliegenden Fall ist die Leiterplatte 10 direkt mit dem Aufnahmeblock 20 verbunden. Ansonsten entspricht die Anordnung der Figuren 9a - c der Anordnung gemäß den Figuren 8a - c. Da die Leiterplatte 10 selbst elastisch verformbar ist, übernimmt diese selbst die Funktion des federnden Gelenks.

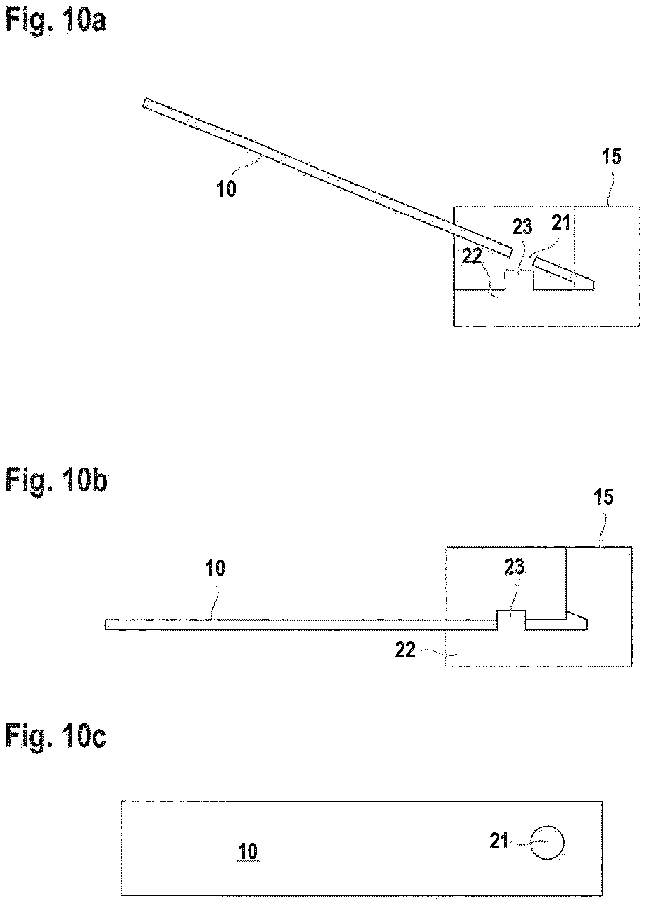

Die Figuren 10 a- c zeigen ein weiteres Beispiel einer spielfreien Ankopplung der Leiterplatte 10 an die Gehäusekappe 15. Die Leiterplatte 10 weist eine kreisförmige Bohrung 21 auf, wie insbesondere Figur 10c zeigt. Von einem Bodenteil 22 der Gehäusekappe 15 steht ein kreisscheibenförmiger Sockel 23 hervor. Die Leiterplatte 10 wird dann durch Kippen in Richtung des Bodenteils 22 geführt und die Bohrung 21 am Sockel 23 eingerastet.

Die Aussparung (21) in der Leiterplatte sowie der Sockel (23) muss nicht zwingend eine Bohrung sein, sondern kann auch anders geformt sein.

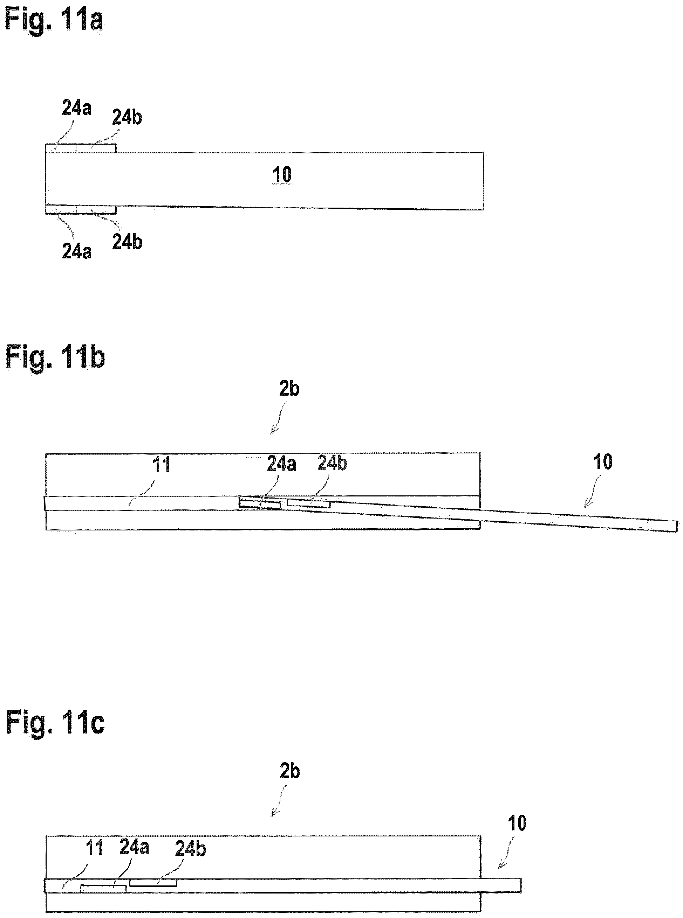

Die Figuren 11a - 11c zeigen ein weiteres Ausführungsbeispiel zur spielfreien Lagerung der Leiterplatte 10 in Nuten 11 des Gehäuses 2b.

Wie Figur 11a zeigt, sind an einem Ende der Leiterplatte 10 deren Randbereiche verbreitert. Dort sind seitlich hervorstehende Leiterplattensegmente 24a, b vorgesehen, wobei wesentlich ist, dass diese Leiterplattensegmente 24a, b in unterschiedlichen Höhenlagen der Leiterplatte 10 vorgesehen sind.

Zur Montage der Leiterplatte 10 wird diese schräg mit den Leiterplattensegmenten 24a, b in die Nuten 11 eingeschoben (Figur 11b). Da sich die Leiterplattensegmente 24a, b in unterschiedlichen Höhenlagen befinden, kann dies ohne Verklemmen der Leiterplattensegmente 24a, b in den Nuten 11 bewerkstelligt werden. Dann wird die Leiterplatte 10 in die Ebene der Nuten 11 gekippt. In dieser Sollposition, die bei Aufsetzen der Gehäusekappe 15 auf den Gehäusegrundkörper 14 lagefixiert ist, verklemmen sich die Leiterplattensegmente 24a, b in den Nuten 11 und sorgen für eine sichere Lagefixierung der Leiterplatte 10 (Figur 11c).

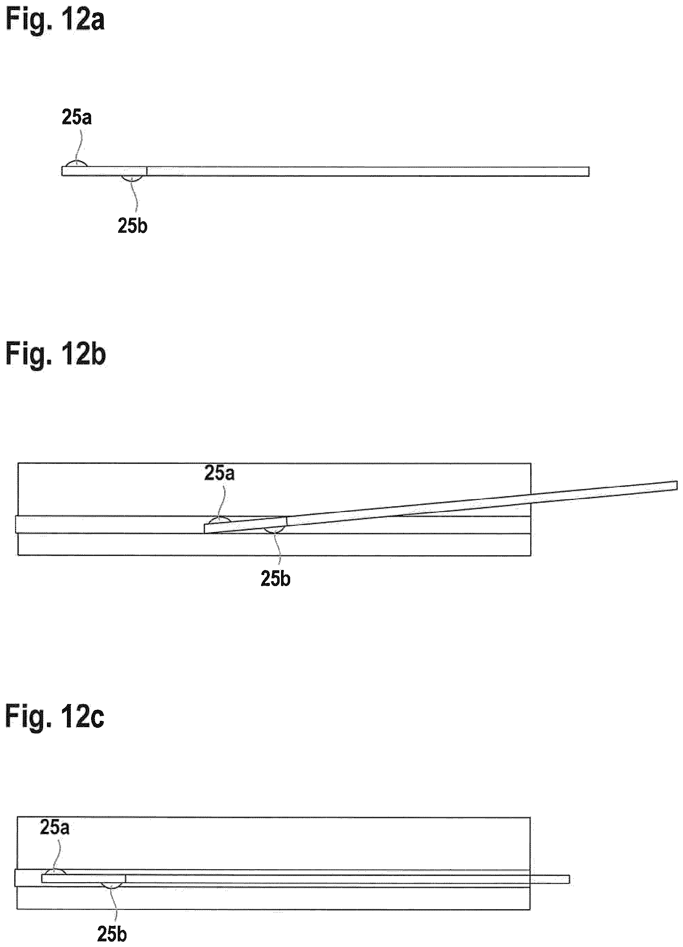

Die Figuren 12a - c zeigen eine Variante der Anordnung von den Figuren 11a -c. In diesem Fall sind in den verbreiterten Randbereichen der Leiterplatte 10 anstelle der Leiterplattensegmente 24a, b Lötzinnpads 25a, b oder aufgelötete Bauteile als Erhöhungen vorgesehen.
(24a,b)Leiterplattensegment
(25a,b)Lötzinnpad
(26) Federgelenk
(27) Filmgelenkaufnahme
(28) Dorn
(28a) Nut mit dornartigen Kanten
(28b) Fase an der Leiterplatte
(29) Aussparung
(30) Vorsprung

## Patentansprüche

1. Optischer Sensor zur Erfassung von Objekten innerhalb eines Überwachungsbereichs, mit Sensorkomponenten und Elektronikkomponenten, welche in wenigstens einem Gehäuse (2a, 2b) angeordnet sind, in welchem wenigstens eine Sensorkomponenten und/oder Elektronikkomponenten aufnehmende Leiterplatte (10) gelagert ist, **dadurch gekennzeichnet, dass** die Leiterplatte (10) in einer Aufnahme des Gehäuses (2a, 2b) dadurch spielfrei gelagert ist, dass bei in eine Sollposition in der Aufnahme eingebrachten Leiterplatte (10) Elemente an der Leiterplatte (10) verformt sind, wobei die Elemente an der Leiterplatte (10) in der Aufnahme so verformbar sind, dass diese spielfrei in der Aufnahme gelagert sind.

2. Optischer Sensor nach Anspruch 1, **dadurch gekennzeichnet, dass** die Leiterplatte (10) als verformbares Element in einem Randbereich ein federndes Gelenk ausbildet, welches durch Verformung auslenkbar ist und welches in Eingriff mit der Aufnahme bringbar ist.

3. Optischer Sensor nach Anspruch 2, **dadurch gekennzeichnet, dass** das federnde Gelenk ein einstückig mit einem ebenen Körperteil der Leiterplatte (10) ausgebildetes und durch eine Aussparung (13) von diesen abgesetztes Filmgelenk (12) ist.

4. Optischer Sensor nach Anspruch 3, **dadurch gekennzeichnet, dass** in einer Ruhestellung das Filmgelenk (12) seitlich über den Rand des Körperteils hervorsteht, und dass bei in eine die Aufnahme ausbildenden Nut (11) eingeführter Leiterplatte (10) das Filmgelenk (12) zwischen dem Körperteil und der Nut (11) verpresst ist, wodurch die Leiterplatte (10) spielfrei in der Aufnahme gelagert ist.

5. Optischer Sensor nach Anspruch 4, **dadurch gekennzeichnet, dass** das Filmgelenk (12) wenigstens eine Anfasung (12a) aufweist, wodurch bei in der Nut (11) gelagerter Leiterplatte (10) das Filmgelenk (12) zusätzlich senkrecht oder schräg zur Ebene der Leiterplatte (10) ausgelenkt ist.

6. Optischer Sensor nach einem der Ansprüche 4 oder 5, **dadurch gekennzeichnet, dass** die Aufnahme zwei parallel zueinander verlaufende, im Gehäuse (2a, 2b) angeordnete Nuten (11) aufweist, in welchen gegenüberliegende Ränder der Leiterplatte (10) gelagert sind.

7. Optischer Sensor nach Anspruch 2, **dadurch gekennzeichnet, dass** das Gehäuse (2a, 2b) einen Gehäusegrundkörper (14) und eine auf eine Öffnung des Gehäusegrundkörpers (14) aufsetzbare Gehäusekappe (15) aufweist, wobei gegenüberliegende Randbereiche der Leiterplatte (10) in Nuten (11) des Gehäusegrundkörpers (14) gelagert werden können, welche Bestandteile der Aufnahme sind.

8. Optischer Sensor nach Anspruch 7, **dadurch gekennzeichnet, dass** das federnde Gelenk der Leiterplatte (10) spielfrei an einer Innendwand der Gehäusekappe (15) gelagert ist.

9. Optischer Sensor nach Anspruch 8, **dadurch gekennzeichnet, dass** das federnde Gelenk mittels eines Formschlusselements (17) spielfrei an der Innenwand der Gehäusekappe (15) gelagert ist.

10. Optischer Sensor nach Anspruch 9, **dadurch gekennzeichnet, dass** durch das Formschlusselement (17) das federnde Gelenk aus der Ebene der Leiterplatte (10) heraus ausgelenkt ist.

11. Optischer Sensor nach Anspruch 7, **dadurch gekennzeichnet, dass** ein stirnseitiger Abschnitt der Leiterplatte (10) mittels des federnden Gelenks in der Gehäusekappe (15) so gelagert ist, dass die Leiterplatte (10) schräg zur Längsachse der Gehäusekappe (15) angeordnet ist und dass nach Einführen der Leiterplatte (10) in die Nuten (11) des Gehäusegrundkörpers (14) das federnde Gelenk gebogen wird, wodurch die Randbereiche der Leiterplatte (10) unter Spannung in den Nuten (11) gelagert sind.

12. Optischer Sensor nach Anspruch 11, **dadurch gekennzeichnet, dass** das federnde Gelenk ein an den stirnseitigen Rand der Leiterplatte (10) anschließendes separates Element ist.

13. Optischer Sensor nach Anspruch 11, **dadurch gekennzeichnet, dass** die Leiterplatte (10) selbst das federnde Gelenk ausbildet.

14. Optischer Sensor nach Anspruch 7, **dadurch gekennzeichnet, dass** die Leiterplatte (10) einen Bereich mit verbreiterten Randbereichen aufweist, wobei diese Randbereiche unterschiedliche Höhen aufweisen.

15. Optischer Sensor nach Anspruch 8, **dadurch gekennzeichnet, dass** die Randbereiche gegenüberliegend an der Leiterplatte (10) angeordnet sind.

16. Optischer Sensor nach einem der Ansprüche 14 oder 15, **dadurch gekennzeichnet, dass** bei schrägem Einführen der Randbereiche der Leiterplatte (10) in die Nuten (11) die Randbereiche mit Spiel in den Nuten (11) geführt sind, und dass durch Ausrichten der Leiterplatte (10) in der Ebene der Nuten (11) die Randbereiche der Leiterplatte (10) in den Nuten (11) festgeklemmt sind.

17. Optischer Sensor nach einem der Ansprüche 14 - 16, **dadurch gekennzeichnet, dass** lokale Erhöhungen in den Randbereichen der Leiterplatte (10) Bestandteile der Leiterplatte (10) sind.

18. Optischer Sensor nach einem der Ansprüche 14 - 16, **dadurch gekennzeichnet, dass** lokale Erhöhungen in den Randbereichen der Leiterplatte (10) von zusätzlichen Elementen gebildet sind.

19. Optischer Sensor nach Anspruch 18, **dadurch gekennzeichnet, dass** die zusätzlichen Elemente Lötpads, metallische Elemente oder Lötstopplack-Segmente sind.

20. Optischer Sensor nach Anspruch 7, **dadurch gekennzeichnet, dass** die Leiterplatte (10) durch eine Klemmverbindung mit der Gehäusekappe (15) verbunden ist.

21. Optischer Sensor nach einem der Ansprüche 1 bis 20, **dadurch gekennzeichnet, dass** die Leiterplatte (10) elektrisch leitfähige Kontaktelemente (18) aufweist, wobei bei in die Aufnahme eingeführter Leiterplatte (10) diese Kontaktelementen (18) mit elektrisch leitfähigen Kontaktelemente (18) der Aufnahme kontaktiert sind.

22. Optischer Sensor nach Anspruch 21, **dadurch gekennzeichnet, dass** die Kontaktelemente (18) der Leiterplatte (10) Bauelemente oder Leiterbahnen sind.

23. Optischer Sensor nach einem der Ansprüche 21 bis 22, **dadurch gekennzeichnet, dass** die Kontaktelemente (18) der Leiterplatte (10) aus Kupfer bestehen oder verzinnt oder vergoldet sind.

24. Optischer Sensor nach einem der Ansprüche 21 bis 23, **dadurch gekennzeichnet, dass** die Kontaktelemente (18) der Aufnahme aus leitfähigen Beschichtungen oder aus leitfähigen, oberflächenbehandelten Materialien bestehen.

25. Optischer Sensor nach einem der Ansprüche 1 bis 24, **dadurch gekennzeichnet, dass** dieser ein Sicherheitssensor ist.

## Claims

1. An optical sensor for detecting objects within a monitoring area, having sensor components and electronic components which are arranged in at least one housing (2a, 2b) in which at least one printed circuit board (10) accommodating sensor components and/or electronic components is mounted, **characterised in that in that** the printed circuit board (10) is mounted free of play in a receptacle of the housing (2a, 2b), **in that** elements on the printed circuit board (10) are deformed when the printed circuit board (10) is brought into a desired position in the receptacle, the elements on the printed circuit board (10) being deformable in the receptacle in such a way that they are mounted free of play in the receptacle.

2. An optical sensor according to claim 1, **characterised in that** the printed circuit board (10) forms a resilient joint as a deformable element in an edge region, which can be deflected by deformation and which can be brought into engagement with the receptacle.

3. An optical sensor according to claim 2, **characterised in that** the resilient joint is a film joint (12) formed integrally with a flat body part of the printed circuit board (10) and set off from the latter by a recess (13).

4. An optical sensor according to claim 3, **characterised in that** in a rest position the film joint (12) projects laterally beyond the edge of the body part, and **in that** when the printed circuit board (10) is inserted into a groove (11) forming the receptacle, the film joint (12) is pressed between the body part and the groove (11), as a result of which the printed circuit board (10) is mounted in the receptacle without play.

5. An optical sensor according to claim 4, **characterised in that** the film joint (12) has at least one chamfer (12a), whereby the film joint (12) is additionally deflected perpendicularly or obliquely to the plane of the printed circuit board (10) when the printed circuit board (10) is mounted in the groove (11).

6. An optical sensor according to one of claims 4 or 5, **characterised in that** the receptacle has two grooves (11) which run parallel to one another and are arranged in the housing (2a, 2b) and in which opposite edges of the printed circuit board (10) are mounted.

7. An optical sensor according to claim 2, **characterised in that** the housing (2a, 2b) has a housing base body (14) and a housing cap (15) which can be placed on an opening of the housing base body (14), wherein opposite edge regions of the printed circuit board (10) can be mounted in grooves (11) of the housing base body (14), which are components of the receptacle.

8. An optical sensor according to claim 7, **characterised in that** the resilient joint of the printed circuit board (10) is mounted without play on an inner end wall of the housing cap (15).

9. An optical sensor according to claim 8, **characterised in that** the resilient joint is mounted without play on the inner wall of the housing cap (15) by means of a positive-locking element (17).

10. An optical sensor according to claim 9, **characterised in that** the resilient joint is deflected out of the plane of the printed circuit board (10) by the positive locking element (17).

11. An optical sensor according to claim 7, **characterised in that** an end-face section of the printed circuit board (10) is mounted in the housing cap (15) by means of the resilient joint in such a way that the printed circuit board (10) is arranged at an angle to the longitudinal axis of the housing cap (15) and that, after insertion of the printed circuit board (10) into the grooves (11) of the housing base body (14), the resilient joint is bent, as a result of which the edge regions of the printed circuit board (10) are mounted under tension in the grooves (11).

12. An optical sensor according to claim 11, **characterised in that** the resilient joint is a separate element adjoining the front edge of the printed circuit board (10).

13. An optical sensor according to claim 11, **characterised in that** the printed circuit board (10) itself forms the resilient joint.

14. An optical sensor according to claim 7, **characterised in that** the printed circuit board (10) has a region with widened edge regions, these edge regions having different heights.

15. An optical sensor according to claim 8, **characterised in that** the edge regions are arranged opposite one another on the printed circuit board (10).

16. An optical sensor according to one of claims 14 or 15, **characterised in that**, when the edge regions of the printed circuit board (10) are inserted obliquely into the grooves (11), the edge regions are guided with play in the grooves (11), and **in that** the edge regions of the printed circuit board (10) are clamped in the grooves (11) by aligning the printed circuit board (10) in the plane of the grooves (11).

17. An optical sensor according to one of claims 14 - 16, **characterised in that** local elevations in the edge regions of the printed circuit board (10) are components of the printed circuit board (10).

18. An optical sensor according to one of claims 14 - 16, **characterised in that** local elevations in the edge regions of the printed circuit board (10) are formed by additional elements.

19. An optical sensor according to claim 18, **characterised in that** the additional elements are solder pads, metallic elements or solder resist segments.

20. An optical sensor according to claim 7, **characterised in that** the printed circuit board (10) is connected to the housing cap (15) by a clamp connection.

21. An optical sensor according to one of claims 1 to 20, **characterised in that** the printed circuit board (10) has electrically conductive contact elements (18), wherein, when the printed circuit board (10) is inserted into the receptacle, these contact elements (18) are in contact with electrically conductive contact elements (18) of the receptacle.

22. An optical sensor according to claim 21, **characterised in that** the contact elements (18) of the printed circuit board (10) are components or conductor tracks.

23. An optical sensor according to one of claims 21 to 22, **characterised in that** the contact elements (18) of the printed circuit board (10) are made of copper or are tin-plated or gold-plated.

24. An optical sensor according to one of claims 21 to 23, **characterised in that** the contact elements (18) of the receptacle consist of conductive coatings or of conductive, surface-treated materials.

25. An optical sensor according to one of claims 1 to 24, **characterised in that** it is a safety sensor.

## Revendications

1. Capteur optique pour la détection d'objets dans une zone de surveillance, comportant des composants de capteur et des composants électroniques disposés dans au moins un boîtier (2a, 2b) dans lequel est montée au moins une carte de circuit imprimé (10) logeant des composants de capteur et/ou des composants électroniques, **caractérisé en ce que** la carte de circuit imprimé (10) est montée sans jeu dans un réceptacle du boîtier (2a, 2b), **en ce que** des éléments de la carte de circuit imprimé (10) sont déformés lorsque la carte de circuit imprimé (10) est amenée dans une position souhaitée dans le logement, les éléments de la carte de circuit imprimé (10) étant déformables dans le logement de telle sorte qu'ils sont montés sans jeu dans le logement.

2. Capteur optique selon la revendication 1, **caractérisé en ce que** la carte de circuit imprimé (10) forme un joint élastique en tant qu'élément déformable dans une zone de bord, qui peut être dévié par déformation et qui peut être mis en contact avec le réceptacle.

3. Capteur optique selon la revendication 2, **caractérisé en ce que** le joint élastique est un joint de film (12) formé intégralement avec une partie plate du corps de la carte de circuit imprimé (10) et séparé de cette dernière par une cavité (13).

4. Capteur optique selon la revendication 3, **caractérisé en ce qu'**en position de repos, le joint de film (12) dépasse latéralement le bord de la partie du corps, et par le fait que lorsque la carte de circuit imprimé (10) est insérée dans une rainure (11) formant le réceptacle, le joint de film (12) est pressé entre la partie du corps et la rainure (11), ce qui fait que la carte de circuit imprimé (10) est montée sans jeu dans le réceptacle.

5. Capteur optique selon la revendication 4, **caractérisé en ce que** le joint de film (12) présente au moins un chanfrein (12a), de sorte que le joint de film (12) est en outre dévié perpendiculairement ou obliquement au plan de la carte de circuit imprimé (10) lorsque la carte de circuit imprimé (10) est montée dans la rainure (11).

6. Capteur optique selon l'une des revendications 4 ou 5, **caractérisé en ce que** le réceptacle comporte deux rainures (11) parallèles l'une à l'autre, disposées dans le boîtier (2a, 2b) et dans lesquelles sont montés les bords opposés de la carte de circuit imprimé (10).

7. Capteur optique selon la revendication 2, **caractérisé en ce que** le boîtier (2a, 2b) a un corps de base (14) et un capuchon de boîtier (15) qui peut être placé sur une ouverture du corps de base du boîtier (14), dans lequel des zones de bord opposé de la carte de circuit imprimé (10) peuvent être montées dans des rainures (11) du corps de base du boîtier (14), qui sont des composants du réceptacle.

8. Capteur optique selon la revendication 7, **caractérisé en ce que** le joint élastique de la carte de circuit imprimé (10) est monté sans jeu sur une paroi d'extrémité intérieure du capuchon du boîtier (15).

9. Capteur optique selon la revendication 8, **caractérisé en ce que** le joint élastique est monté sans jeu sur la paroi intérieure du couvercle du boîtier (15) au moyen d'un élément de verrouillage positif (17).

10. Capteur optique selon la revendication 9, **caractérisé en ce que** le joint élastique est dévié hors du plan de la carte de circuit imprimé (10) par l'élément de verrouillage positif (17).

11. Capteur optique selon la revendication 7, **caractérisé par le fait qu'**une section de la face frontale de la carte de circuit imprimé (10) est montée dans le couvercle du boîtier (15) au moyen de l'articulation élastique de telle sorte que la carte de circuit imprimé (10) est disposée à un angle par rapport à l'axe longitudinal du couvercle du boîtier (15) et que, après l'insertion de la carte de circuit imprimé (10) dans les rainures (11) du corps de base du boîtier (14), l'articulation élastique soit pliée, de sorte que les zones de bord de la carte de circuit imprimé (10) soient montées sous tension dans les rainures (11).

12. Capteur optique selon la revendication 11, **caractérisé en ce que** le joint élastique est un élément séparé adjacent au bord avant de la carte de circuit imprimé (10).

13. Capteur optique selon la revendication 11, **caractérisé en ce que** la carte de circuit imprimé (10) forme elle-même le joint élastique.

14. Capteur optique selon la revendication 7, **caractérisé en ce que** la carte de circuit imprimé (10) présente une région avec des zones de bord élargies, ces zones de bord ayant des hauteurs différentes.

15. Capteur optique selon la revendication 8, **caractérisé en ce que** les zones de bord sont disposées l'une en face de l'autre sur la carte de circuit imprimé (10).

16. Capteur optique selon l'une des revendications 14 ou 15, **caractérisé en ce que**, lorsque les zones de bord de la carte de circuit imprimé (10) sont insérées obliquement dans les rainures (11), les zones de bord sont guidées avec jeu dans les rainures (11), et **en ce que** les zones de bord de la carte de circuit imprimé (10) sont serrées dans les rainures (11) en alignant la carte de circuit imprimé (10) dans le plan des rainures (11).

17. Capteur optique selon l'une des revendications 14 à 16, **caractérisé en ce que** les élévations locales dans les zones de bord de la carte de circuit imprimé (10) sont des composants de la carte de circuit imprimé (10).

18. Capteur optique selon l'une des revendications 14 à 16, **caractérisé en ce que** les élévations locales dans les zones de bord de la carte de circuit imprimé (10) sont formées par des éléments supplémentaires.

19. Capteur optique selon la revendication 18, **caractérisé en ce que** les éléments supplémentaires sont des plots de soudure, des éléments métalliques ou des segments de réserve de soudure.

20. Capteur optique selon la revendication 7, **caractérisé en ce que** la carte de circuit imprimé (10) est reliée au couvercle du boîtier (15) par une connexion à pince.

21. Capteur optique selon l'une des revendications 1 à 20, **caractérisé en ce que** la carte de circuit imprimé (10) comporte des éléments de contact électriquement conducteurs (18), dans lesquels, lorsque la carte de circuit imprimé (10) est insérée dans le réceptacle, ces éléments de contact (18) sont en contact avec des éléments de contact électriquement conducteurs (18) du réceptacle.

22. Capteur optique selon la revendication 21, **caractérisé en ce que** les éléments de contact (18) de la carte de circuit imprimé (10) sont des composants ou des pistes conductrices.

23. Capteur optique selon l'une des revendications 21 à 22, **caractérisé en ce que** les éléments de contact (18) de la carte de circuit imprimé (10) sont en cuivre, étamés ou dorés.

24. Capteur optique selon l'une des revendications 21 à 23, **caractérisé en ce que** les éléments de contact (18) du réceptacle sont constitués de revêtements conducteurs ou de matériaux conducteurs traités en surface.

25. Capteur optique selon l'une des revendications 1 à 24, **caractérisé par le fait qu'**il s'agit d'un capteur de sécurité.
